# EUROPEAN PATENT APPLICATION

(11) **EP 4 766 033 A1**
(43) Date of publication of application: **24.06.2026**
(21) Application number: 25220310.4
(22) Date of filing: 03.12.2025
(51) Int. Cl.: H05K 1/02, H05K 1/03, H05K 1/189

(54) **TEAR-PREVENTION STRUCTURE FOR MULTILAYER SUBSTRATE**

(30) Priority: 23.12.2024 JP 2024226513
(71) Applicant: Alps Alpine Co., Ltd., Ota-ku, Tokyo 145-8501 (JP)
(72) Inventor: Yasumoto, Takashi, Iwaki-city Fukushima (JP)
(74) Representative: Schmitt-Nilson Schraud Waibel Wohlfrom Patentanwälte Partnerschaft mbB

(57) **Abstract**

A tear-prevention structure for a multilayer substrate having a plurality of interconnect layers laminated via an insulating layer is provided. The tear-prevention structure includes a tear-prevention conductor pattern formed in proximity to a slit or a hole provided in the multilayer substrate, and the conductor pattern is formed in at least two layers of the plurality of the interconnect layers of the multilayer substrate.

## Description

The present disclosure relates to a multilayer substrate having a plurality of interconnect layers laminated via an insulating layer, and more particularly to a tear-prevention structure formed around a slot or a mounting hole in the multilayer substrate.

Micro light emitting diodes (micro-LEDs) capable of directly displaying images have been developed, and their implementation on bendable film-type substrates is under consideration. As a typical film-type substrate, a flexible printed circuit board (hereinafter referred to as an "FPC substrate") is provided by slits or holes for facilitating bending or for mounting the substrate. For example, JP2010-074101 A discloses an FPC substrate in which a reinforcing conductor pattern is formed in a slot portion so that an interconnect pattern will not be damaged even when cracks occur.

In film substrates, insulating layers such as of PI (polyimide), PET (polyethylene terephthalate), or PC (polycarbonate), mainly having a thickness of 100 µm or less, are used. An FPC substrate is manufactured by laminating conductor layers onto such insulating layers.

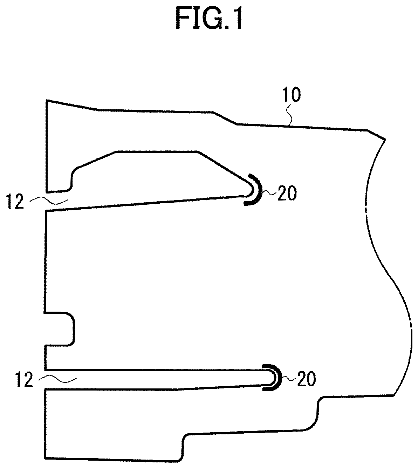

FIG. 1 illustrates an example of a conventional FPC substrate. In the FPC substrate 10, as described above, a slit 12 for facilitating bending is formed, and the planar shape of the slit portion is not rectangular but circular or rounded (R). Furthermore, as disclosed in JP2010-074101 A, a circular conductor pattern 20 for reinforcement is formed in proximity to the base portion of the slit 12. Although such techniques are generally employed as a structure for preventing tearing at the slit portion, they involve the following problems.
1. The slit portion can easily tear from its base portion due to pulling or snagging.
2. As disclosed in JP2010-074101 A, even if an arcuate or U-shaped reinforcing conductor pattern 20 is provided to make the slit portion less prone to tearing, the effect is weak when only a single layer of conductor pattern 20 is used.
3. When the slit or the reinforcing conductor pattern 20 for tear prevention constitutes a movable part, cracks are more likely to occur in the conductor pattern 20 than in the film material due to bending.
4. When a crack propagates from the slit portion and reaches the reinforcing conductor pattern 20, the FPC substrate can easily break.

The present disclosure relates to a tear-prevention structure and a multilayer substrate according to the appended claims. Embodiments are disclosed in the dependent claims. According to an aspect of the present disclosure, a tear-prevention structure for a multilayer substrate having a plurality of interconnect layers laminated via an insulating layer is provided. The tear-prevention structure includes a tear-prevention conductor pattern formed in proximity to a slit or a hole provided in the multilayer substrate, and the conductor pattern is formed in at least two layers of the plurality of the interconnect layers of the multilayer substrate.

Other objects and further features of the present disclosure will be apparent from the following detailed description when read in conjunction with the accompanying drawings, in which:
FIG. 1 is a schematic plan view illustrating a slit portion formed in a conventional FPC substrate and a reinforcing conductor pattern;
FIG. 2A is a schematic top view of an FPC substrate according to a first embodiment of the present disclosure, and FIG. 2B is a schematic cross-sectional view taken along the line A-A thereof;
FIGS. 3A and 3B are diagrams of a conventional FPC substrate as a comparative example, where FIG. 3A is a schematic top view thereof, and FIG. 3B is a schematic cross-sectional view taken along the line A-A thereof;
FIG. 4A is a schematic top view of an FPC substrate according to a second embodiment of the present disclosure, and FIG. 4B is a schematic cross-sectional view taken along the line A-A thereof;
FIG. 5A is a schematic top view of an FPC substrate according to a third embodiment of the present disclosure, and FIG. 5B is a schematic cross-sectional view taken along the line A-A thereof;
FIG. 6A is a schematic top view of an FPC substrate according to a fourth embodiment of the present disclosure, and FIG. 6B is a schematic cross-sectional view taken along the line A-A thereof;
FIG. 7A is a schematic top view of an FPC substrate according to a fifth embodiment of the present disclosure, and FIG. 7B is a schematic cross-sectional view taken along the line A-A thereof;
FIG. 8A is a schematic top view of an FPC substrate according to a sixth embodiment of the present disclosure, and FIG. 8B is a schematic cross-sectional view taken along the line A-A thereof; and
FIGS. 9A and 9B are schematic top views of an FPC substrate according to a seventh embodiment of the present disclosure, and FIG. 9C is a schematic cross-sectional view thereof.

According to the present disclosure, it is desirable to provide a tear-prevention structure for a multilayer substrate having higher strength than conventional structures.

According to the present disclosure, since tear-prevention conductor patterns are formed in at least two interconnect layers, the strength of the tear-prevention structure can be enhanced compared to conventional structures.

The present disclosure according to an aspect relates to a multilayer substrate having a plurality of interconnect layers laminated via an insulating layer, and more particularly to a tear-prevention structure provided with a slit or a mounting hole formed in a flexible multilayer substrate having flexibility. In embodiments of the multilayer substrate, light-emitting elements such as micro LEDs, circuit elements, or semiconductor packages are mounted. It should be noted that the drawings referred to in the following description include exaggerated representations to facilitate understanding of the present disclosure and do not directly reflect the actual shapes or scales of the products.

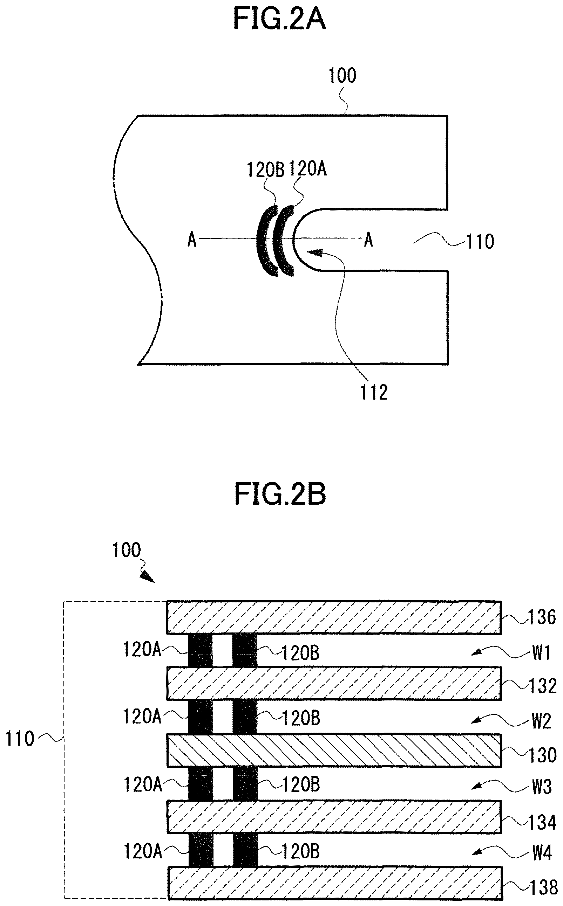

FIG. 2A is a schematic top view of an FPC substrate 100 according to a first embodiment of the present disclosure, and FIG. 2B is a schematic cross-sectional view taken along the line A-A thereof. As illustrated in FIG. 2A, a slit 110 is formed at a certain location of the FPC substrate 100. The slit 110 has, for example, an elongated shape and imparts flexibility to the FPC substrate 100, allowing the FPC substrate 100 to be bent via the slit 110. The position, number, shape, and size of the slit 110 formed in the FPC substrate 100 are not particularly specified and are optionally determined as desired.

The planar shape, which is the outer contour of the base portion 112 of the slit 110, is circular or rounded (R). In addition, two tear-prevention conductor patterns 120A and 120B are formed at positions in proximity to the base portion 112 of the slit 110. The conductor pattern 120A is located closer to the base portion 112, while the conductor pattern 120B is located away from the base portion 112 relative to the conductor pattern 120A. The conductor pattern 120B is formed so as to be spaced apart from the conductor pattern 120A by a predetermined distance. The conductor pattern 120A does not necessarily have to be identical in shape to the conductor pattern 120B; however, in this case, both have an arcuate or curved shape that follows the circular or rounded (R) contour of the base portion 112 of the slit 110.

As illustrated in FIG. 2B, the FPC substrate 100 has a multilayer structure. The multilayer structure includes a plurality of interconnect layers laminated via insulating layers. In the illustrated example, the multilayer structure includes four interconnect layers W1, W2, W3, and W4 and five insulating layers 130, 132, 134, 136 and 138 formed above or below these interconnect layers. In the cross-sectional view of FIG. 2B, the interconnect layers are illustrated in gaps between the insulating layers for ease of explanation; however, it should be noted that, in practice, respective insulating layers are in close contact via an adhesive.

In this embodiment, the two tear-prevention conductor patterns 120A and 120B are formed at the same position (a fixed distance from the base portion of the slit) in each of the interconnect layers W1, W2, W3, and W4 of the multilayer structure. The two conductor patterns 120A and 120B are, for example, formed simultaneously when the interconnect patterns are formed in the interconnect layers W1, W2, W3, and W4.

The method of manufacturing the FPC substrate is not particularly specified. For example, a base film 130 with the interconnect layers W2 and W3 formed on its upper and lower surfaces is prepared. The base film 130 is, for example, a flexible film such as polyimide or a transparent film having light-transmitting properties. On the upper and lower surfaces of the base film 130, conductor films such as copper foil are formed over the entire surface as the interconnect layers W2 and W3. Such conductor films are patterned using, for example, an etching process of the subtractive method to form interconnect patterns in the interconnect layers W2 and W3. When forming the interconnect patterns, the conductor films are patterned so that the tear-prevention conductor patterns 120A and 120B remain.

Next, a cover lay (insulating layer) 132 with the interconnect layer W1 formed thereon and a cover lay (insulating layer) 134 with the interconnect layer W4 formed thereon are adhered to the upper and lower surfaces of the base film 130 via an adhesive. When forming interconnect patterns in the interconnect layers W1 and W4, the tear-prevention conductor patterns 120A and 120B are formed simultaneously. Then, a cover lay (insulating layer) 136 is adhered via an adhesive to cover the interconnect layer W1, and a cover lay (insulating layer) 138 is adhered via an adhesive to cover the interconnect layer W4.

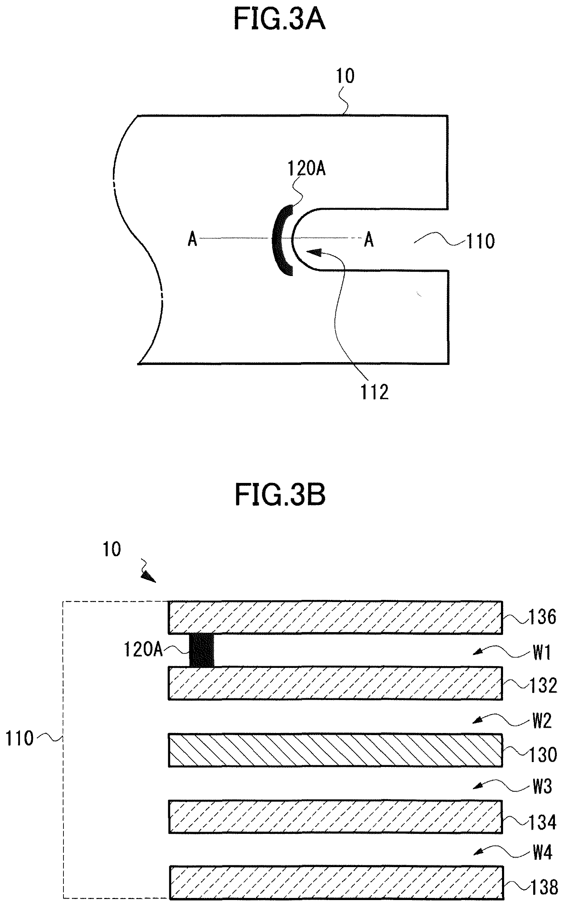

FIG. 3A is a schematic top view of a conventional FPC substrate 10, and FIG. 3B is a schematic cross-sectional view taken along the line A-A thereof. The same reference numerals are used for components having the same configuration as in the first embodiment. In the conventional FPC substrate 10, a tear-prevention conductor pattern 120A is formed in a single interconnect layer W1. In contrast, in this embodiment, since the tear-prevention conductor patterns 120A and 120B are formed in all of the interconnect layers W1 to W4, the strength of tear prevention can be increased compared to the conventional tear-prevention structure.

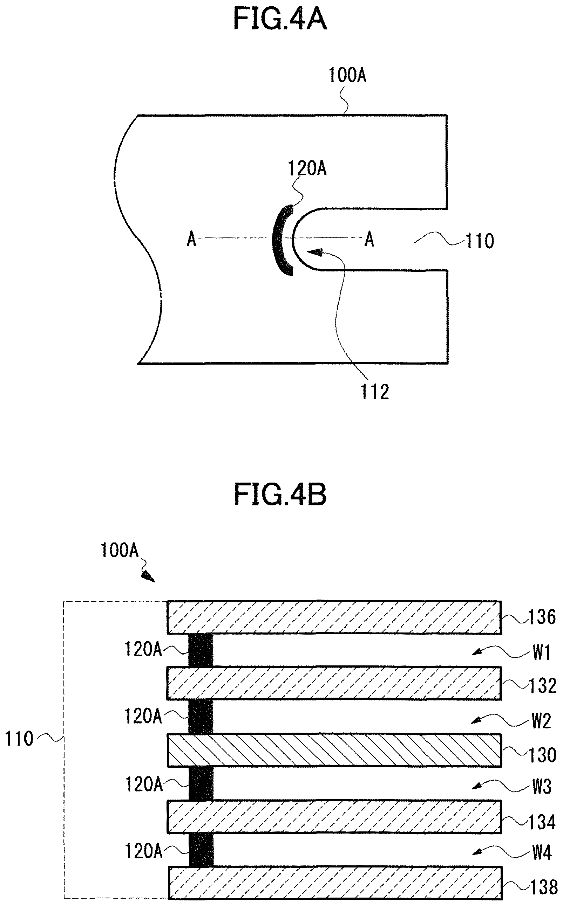

Next, a second embodiment of the present disclosure will be described. FIG. 4A is a schematic top view of an FPC substrate 100A according to the second embodiment, and FIG. 4B is a schematic cross-sectional view taken along the line A-A thereof. The same reference numerals are used for components having the same configuration as in the first embodiment. In the second embodiment, unlike the first embodiment, a single tear-prevention conductor pattern 120A is formed at the same position in each of the interconnect layers W1, W2, W3, and W4 of the FPC substrate 100A.

According to the second embodiment, when the circuit patterns are densely packed and the space for forming the tear-prevention conductor pattern is limited, providing the conductor pattern 120A at the same position in all interconnect layers allows a structure that is resistant to tearing from both the front and back surfaces of the substrate.

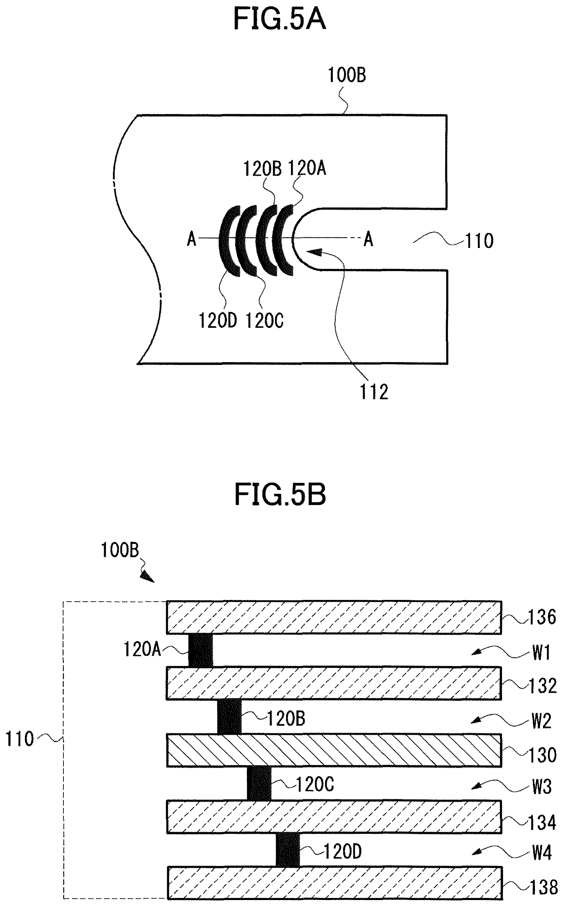

Next, a third embodiment of the present disclosure will be described. FIG. 5A is a schematic top view of an FPC substrate 100B according to the third embodiment, and FIG. 5B is a schematic cross-sectional view taken along the line A-A thereof. The same reference numerals are used for components having the same configuration as in the first embodiment. In the third embodiment, unlike the first and second embodiments, each of the interconnect layers W1, W2, W3, and W4 of the FPC substrate 100B is provided with a single tear-prevention conductor pattern 120A, 120B, 120C, or 120D at positions gradually spaced away from the base portion 112 of the slit 110. The conductor patterns 120A, 120B, 120C, and 120D may all have the same shape, or they may decrease in size as the distance from the base portion 112 of the slit 110 increases.

According to the third embodiment, by varying the positions of the tear-prevention conductor patterns 120A, 120B, 120C, and 120D in the respective interconnect layers, a structure can be provided that prevents the slit portion from tearing all at once when stress is applied to the FPC substrate 100B.

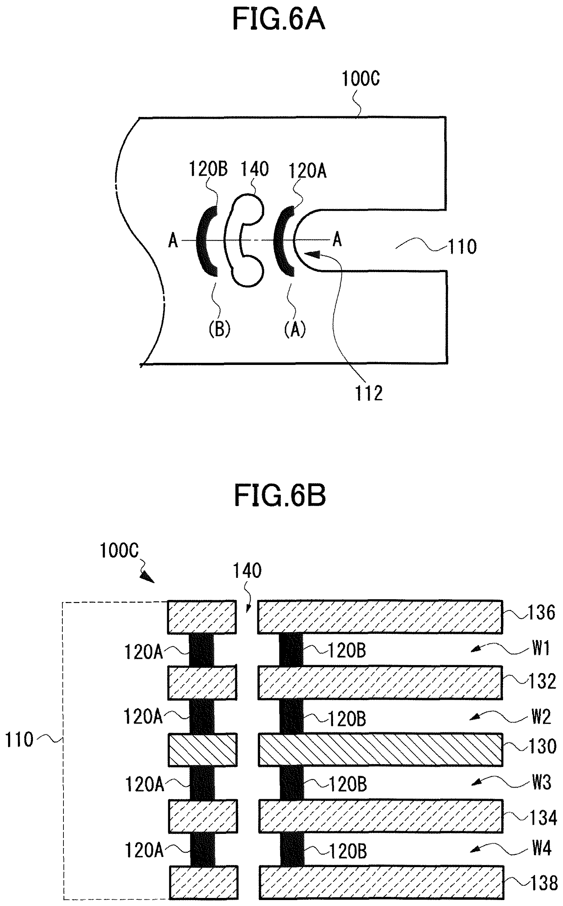

Next, a fourth embodiment of the present disclosure will be described. FIG. 6A is a schematic top view of an FPC substrate 100C according to the fourth embodiment, and FIG. 6B is a schematic cross-sectional view taken along the line A-A thereof. In the FPC substrate 100C of the fourth embodiment, a through-hole 140 is formed between the conductor pattern 120A and the conductor pattern 120B. The through-hole 140 is formed at the same position in the base film 130 and the cover lays 132, 134, 136, and 138. The planar shape of the through-hole 140 is not particularly limited, but preferably has an arcuate shape that follows the planar shapes of the conductor patterns 120A and 120B.

According to the fourth embodiment, by forming the through-hole 140 in all of the insulating layers between the two conductor patterns 120A and 120B, even if portion (A) of the slit 110 tears, the propagation of the tear can be suppressed by the through-hole 140, while maintaining the tear-prevention structure of portion (B).

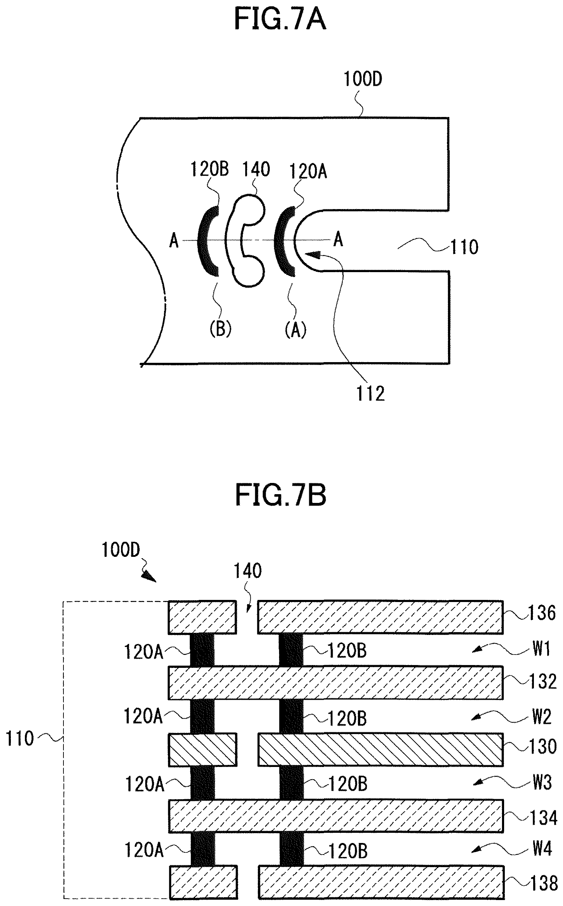

Next, a fifth embodiment of the present disclosure will be described. FIG. 7A is a schematic top view of an FPC substrate 100D according to the fifth embodiment, and FIG. 7B is a schematic cross-sectional view taken along the line A-A thereof. The same reference numerals are used for components having the same configuration as in the fourth embodiment. In the fifth embodiment, the through-hole 140 is formed in the base film 130 and the cover lays 136 and 138, but not in the cover lays 132 and 134, which distinguishes the fifth embodiment from the fourth embodiment.

According to the fifth embodiment, a structure can be provided that imparts suppleness (elasticity) to the substrate while preventing tearing from the outermost front and back layers of the FPC substrate 100D. The positions and layers in which the through-hole 140 is provided can be optionally determined depending on factors such as the thickness of the base film and the cover lays, and the number of laminated insulating layers. For example, no through-hole may be formed in the base film, while a through-hole is formed in the cover lays 136 and 138, or alternatively, a through-hole may be formed only in the base film.

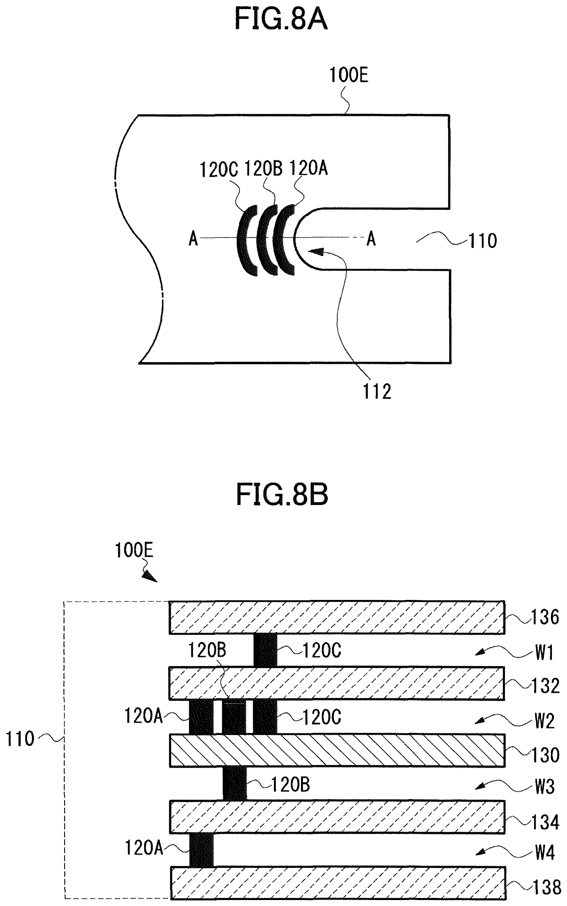

Next, a sixth embodiment of the present disclosure will be described. FIG. 8A is a schematic top view of an FPC substrate 100E according to the sixth embodiment, and FIG. 8B is a schematic cross-sectional view taken along the line A-A thereof. In the sixth embodiment, the tear-prevention conductor patterns are also used as an alignment mark employed when bonding the insulating layers (cover lays). In the case of a multilayer substrate, the alignment marks for bonding the insulating layers are normally provided in a work area outside the substrate. In this embodiment, however, the tear-prevention conductor patterns are also used as the alignment marks, thereby providing a structure in which the alignment marks are formed inside the substrate.

The interconnect layer W1 is formed on the cover lay 132, and the interconnect layer W4 is formed on the cover lay 134, and these are bonded to the base film 130. For example, the conductor pattern 120A formed on the interconnect layer W2 of the base film 130 is used as an alignment mark for bonding the conductor pattern 120A formed on the cover lay 134. Likewise, the conductor pattern 120C formed on the interconnect layer W2 of the base film 130 is used as an alignment mark for bonding the pattern 120C formed on the cover lay 132.

As described above, according to this embodiment, by allowing the conductor patterns to also serve as an alignment mark, it is possible to omit the step of forming the alignment marks in the work area outside the substrate, thereby simplifying the manufacturing process of the FPC substrate while preventing tearing of the FPC substrate.

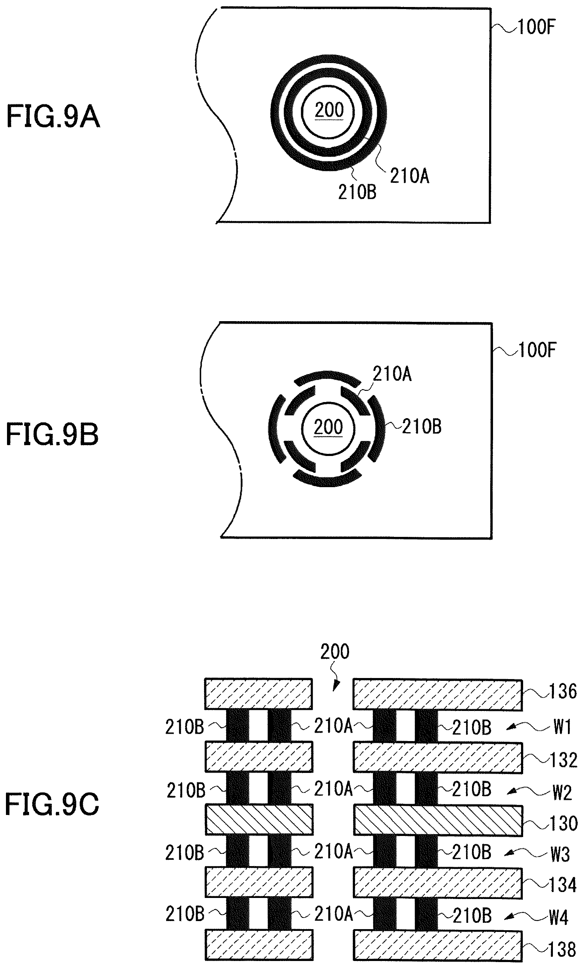

Next, a seventh embodiment of the present disclosure will be described. FIGS. 9A and 9B are schematic top views of an FPC substrate 100F according to the seventh embodiment, and FIG. 9C is a schematic cross-sectional view thereof. In the first through sixth embodiments, tear-prevention structures for slit portions are illustrated. In the seventh embodiment, however, tear-prevention structures for mounting round holes or elliptical holes formed in the FPC substrate are illustrated.

As illustrated in FIG. 9A, a round hole 200 for mounting the substrate to a housing or the like is formed in the FPC substrate 100F. For example, the FPC substrate 100F is fixed to a housing or casing by a screw inserted into the round hole 200.

In the FPC substrate 100F of this embodiment, two concentric circular conductor patterns 210A and 210B are formed around the outer circumference of the round hole 200. The two conductor patterns 210A and 210B are formed in all interconnect layers W1, W2, W3, and W4, for example, in the same manner as in the first embodiment.

In the example illustrated in FIG. 9B, the inner conductor pattern 210A is not a continuous pattern but is composed of four spaced-apart arcuate patterns, and likewise, the outer conductor pattern 210B is not a continuous pattern but is composed of four spaced-apart arcuate patterns. The spaced portions of the inner conductor pattern 210A and the spaced portions of the outer conductor pattern 210B are arranged so as not to align in the radial direction, that is, the spaced portions of the conductor pattern 210A are formed so as to be covered by the pattern of the conductor pattern 210B. As a result, the entire periphery of the round hole 200 is substantially covered by the conductor patterns 210A and 210B, making it difficult for tearing to progress.

The conductor patterns 210A and 210B are not limited to the above configuration. For example, as in the second embodiment, either one of the conductor patterns 210A or 210B may be formed at the same position in all of the interconnect layers W1, W2, W3, and W4. Alternatively, as in the third embodiment, the positions of the conductor patterns 210A/210B may be varied for each interconnect layer W1, W2, W3, and W4. Further, the widths of the conductor patterns 210A and 210B need not necessarily be the same, and one may be larger than the other. Although not illustrated here, in the case of an elliptical hole, similarly to the round hole 200, an elliptical conductor pattern that follows the shape of the elliptical hole may be formed in all of the interconnect layers.

In the above embodiments, the FPC substrate having the interconnect layers W1 to W4 laminated via insulating layers has been illustrated. However, the number of laminated interconnect layers is not specified and may be five or more, or three or fewer. Furthermore, the shape of the tear-prevention conductor pattern may be appropriately determined according to the shape of the slit or hole formed in the multilayer substrate.

As described above, the following advantages are provided:
1. It is possible to prevent the base portion of the slit from easily tearing due to pulling or snagging.
2. It is possible to prevent tearing effectively by providing multiple arcuate or U-shaped tear-prevention patterns in multiple layers.
3. It is possible to further prevent tearing even if the slit or tear-prevention pattern is located in a movable portion and cracks occur in the pattern due to bending.
4. It is possible to further prevent tearing or cutting even if a crack propagates from the outer edge and reaches the pattern.

While embodiments of the present disclosure have been described in detail above, the present disclosure is not limited to the specific embodiments. Various modifications and changes can be made within the scope of the claims.

## Claims

1. A tear-prevention structure for a multilayer substrate, the multilayer substrate having a plurality of interconnect layers laminated via insulating layers, the tear-prevention structure comprising:
a tear-prevention conductor pattern formed in proximity to a slit or a hole provided in the multilayer substrate, the conductor pattern being formed in at least two layers of the plurality of the interconnect layers of the multilayer substrate.

2. The tear-prevention structure according to claim 1, wherein the conductor pattern is formed in each layer of the plurality of the interconnect layers.

3. The tear-prevention structure according to claim 1 or 2, wherein the conductor pattern is formed at different positions in the respective layers of the plurality of the interconnect layers.

4. The tear-prevention structure according to one of claims 1 to 3, wherein a plurality of conductor patterns are formed in a spaced-apart manner in a same interconnect layer, the same interconnect layer being from among the plurality of the interconnect layers.

5. The tear-prevention structure according to claim 4, wherein a through-hole is formed in an insulating layer located between the spaced-apart conductor patterns, the insulating layer being from among the insulating layers.

6. The tear-prevention structure according to claim 4, wherein a through-hole is formed in all or part of the insulating layers located between the spaced-apart conductor patterns.

7. The tear-prevention structure according to one of claims 1 to 6, wherein the conductor pattern also serves as an alignment mark for bonding the insulating layers.

8. A multilayer substrate comprising a tear-prevention structure according to one of the preceding claims.
